**Europäisches Patentamt**

**European Patent Office**

**Office européen des brevets**

(10)

(11) Publication number: **0 253 833**
**B1**

# (12) EUROPEAN PATENT SPECIFICATION

(45) Date of publication of patent specification: **09.01.91**

(51) Int. Cl.⁵: **H 05 K 1/00**

(21) Application number: **87900434.9**

(22) Date of filing: **28.11.86**

(86) International application number:
**PCT/US86/02569**

(87) International publication number:
**WO 87/04040 02.07.87 Gazette 87/14**

(54) **MULTILAYER PRINTED CIRCUIT BOARD.**

(30) Priority: **20.12.85 US 811188**

(43) Date of publication of application:
**27.01.88 Bulletin 88/04**

(45) Publication of the grant of the patent:
**09.01.91 Bulletin 91/02**

(84) Designated Contracting States:
**DE FR GB**

(56) References cited:
**DE-A-2 657 298**
**DE-A-2 934 410**
**GB-A-2 092 830**

**IBM Technical Disclosure Bulletin, vol. 27, no. 9,
Febr. 1985, (New York, US), L.M. Baldauf et
al.:"Use of wideline entry for landless internal
via connection", page 5150**

**IBM Technical Disclosure Bulletin, vol. 25, no. 2,
July 1982, (New York, US), J.J. Kershaw et
al.:"Squarcle power plane clearance lands",
pages 556-557**

(73) Proprietor: **NCR CORPORATION
World Headquarters
Dayton, Ohio 45479 (US)**

(72) Inventor: **CHEN, Paul, T., H.
2474 Brenner Street
St. Paul, MN 55113 (US)**

(74) Representative: **Robinson, Robert George
International Patent Department NCR Limited
206 Marylebone Road
London NW1 6LY (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

### Technical Field

The present invention relates to multilayer printed circuit boards.

### Background Art

Multilayer printed circuit boards are formed of bonded stacks of cards or substrates of insulated material having tracks or lines of printed conductor elements located on their surfaces, the conductor elements being formed typically by the deposition of a metal such as copper on appropriate areas on the substrates or by etching away unwanted areas of a metal film such as copper which is bonded to the substrates. Each card or substrate may be single or double sided, i.e., having lines of conductor elements on one or on both surfaces of the card.

Prior printed circuit boards have been designed with a different circuit on each card or substrate, the circuits being placed in overlying positions so that points for electrical connections between the circuits are congruent to each other. The individual circuits are then connected by drilling through the assembled cards and plating the holes thus formed with a layer of electrically conductive material such as copper. The leads of the circuit components are then mounted within the holes of an exposed planar surface of the assembled board. These leads are then connected with conductor elements on different layers of the board. The conductive layers may be designed to provide different power supply potentials to the circuit or to be used for signal transmission. Since the layout design of prior art high density multilayer printed circuit boards is often complex as result of the intricate patterns of the conductors, together with their interconnecting points, it can be a very time consuming and costly procedure to design such layouts.

From GB-A-2092830 there is further known a voltage printed circuit board including a plurality of through connections extending through an insulating substrate between first and second spaced parallel planes of the board, the through connections being arranged in a pattern of rows and columns; a plurality of first conductive tracks in said first plane each track extending between adjacent columns of through connections and connected to selected ones of the through connections in one or both columns adjacent thereto; a plurality of second tracks in said second plane and extending between adjacent rows of the through connections and transversely of the first tracks and connected to selected ones of the through connections in one or both rows adjacent thereto; the arrangement being such that none of the through-connections are connected to more than one track; whereby desired conductor configurations may be provided on the board by inter-connecting selected tracks by conductive links, between through connections which are connected to those selected tracks and where necessary, introducing discontinuities in said tracks.

### Disclosure of the Invention

It is an object of the invention to provide a multilayer printed circuit board whose design facilitates a high destiny of circuit components mounted on the board.

It is a further object of the invention to provide a multilayer printed circuit board whose construction reduces the time for laying out the patterns on the various substrates of the board.

According to the invention, there is provided a multilayer printed circuit board including a plurality of substrates of electrically insulating material bonded together in a stacked relationship and each having a first surface on which is formed a pattern of electrically conductive material, a plurality of circuit elements mounted on said first surface of an end one of said substrates, and a plurality of plated-through holes extending transversely to the substrates, wherein said pattern of conductive material of each substrate includes a plurality of parallel conductors, a plurality of connecting pads each having a plated through hole passing therethrough and each having a generally square configuration with rounded corners, and a plurality of connecting elements each connecting a corner of an associated connecting pad to an adjacent one of said parallel conductors.

### Brief Description of the Drawings

One embodiment of the invention will now be described by way of example with reference to the accompanying drawings, in which:

Fig. 1 is a plan view of the top layer of a multilayer printed circuit board in accordance with the present invention;

Fig. 2 is an enlarged plan view of a typical domain area of the top layer of the printed circuit board containing DIP I.C. package components;

Fig. 3 is an enlarged plan view of a domain area containing a Macrocell I.C. package component;

Fig. 4 is an enlarged cross-sectional view of a portion of the printed circuit board of the present invention;

Figs. 5A-5D, inclusive, are plan views of portions of various layers of the circuit board showing possible connecting pad arrangements with respect to lines of conductor elements;

Fig. 6 is a detailed view of a portion of a layer of the printed circuit board of the present invention showing a pad connection to segments of the conductor elements;

Fig. 7 is an enlarged detailed view of a typical connecting pad showing its connection to the segments of the conductor elements; and

Fig. 8 is a simplified, enlarged cross-sectional view of a portion of the printed circuit board of the present invention.

### Best Mode for Carrying Out the Invention

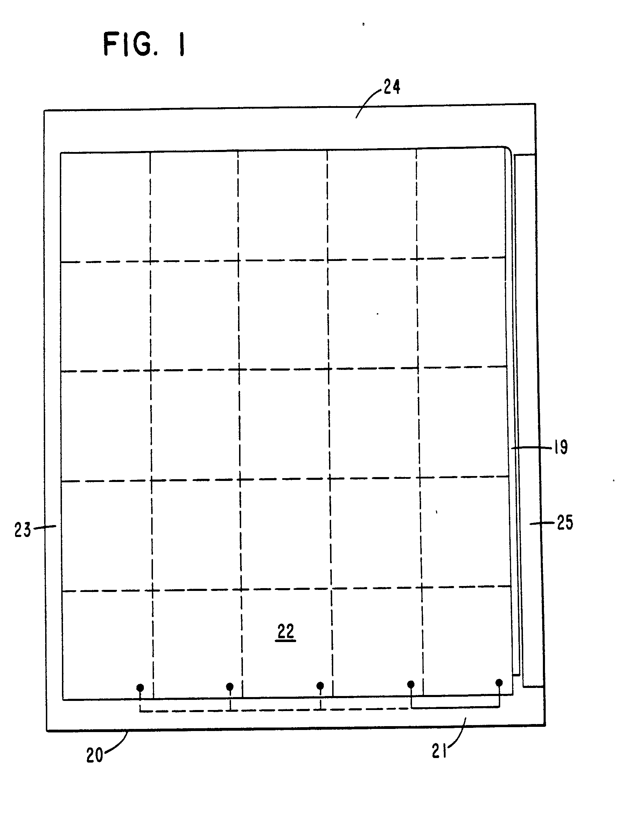

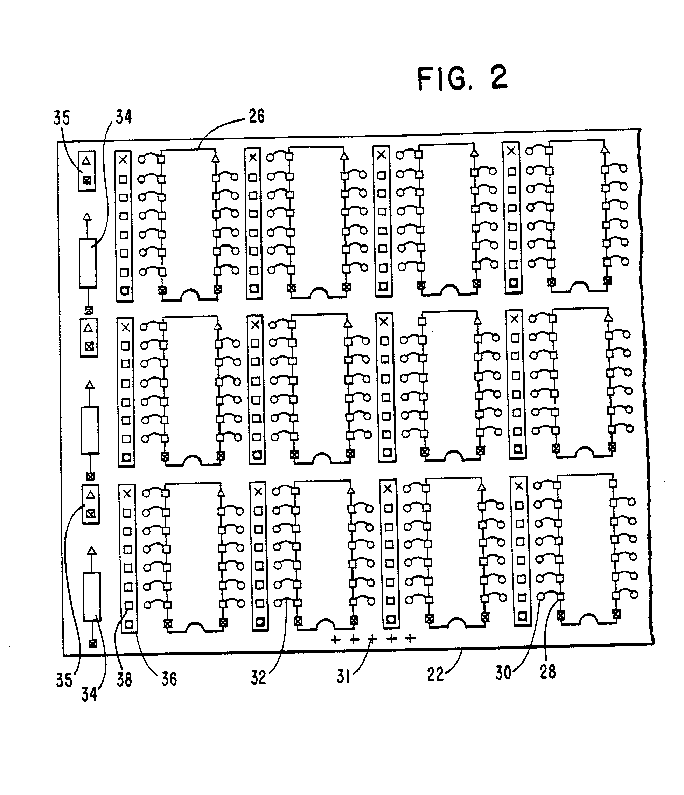

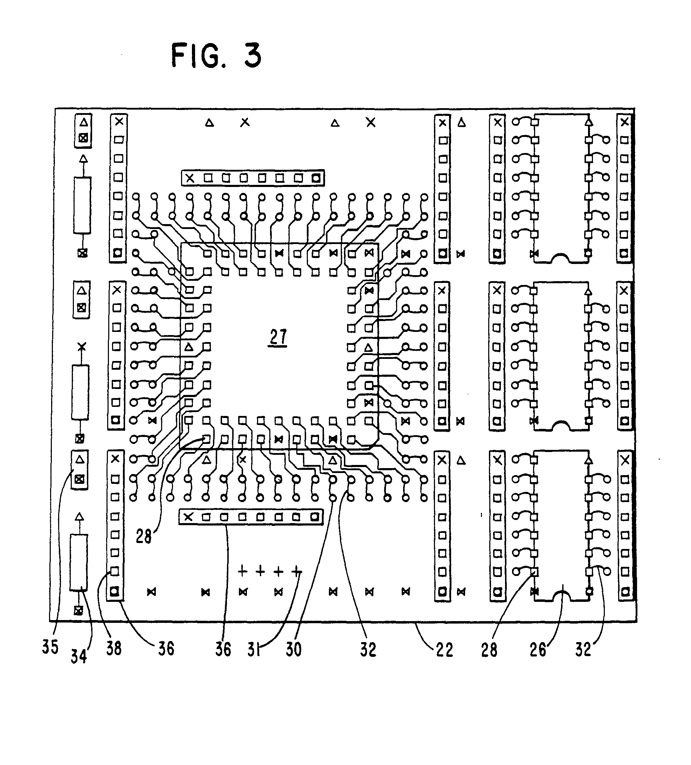

Referring to Fig. 1, there is shown a plan view of the top layer of a multilayer printed circuit board 20 constructed in accordance with the present invention. The surface of the top layer of the board 20 comprises a plurality of equal surface areas or "domains" 22 in which preferably there are mounted the same number of I.C. packages. The top surfaces of each of the remaining layers of the circuit board have a similar layout of equal domain areas. The area 24 of the circuit board 20, located adjacent the upper edge of the circuit board, may accommodate other circuit components. The area 25 accommodates connecting pins of the board for connecting the board to other printed circuit boards of the same logic deck while the area 23 accommodates connectors for the logic deck cable connection (not shown). The area 21 is designated for test lines (not shown) which are useful in monitoring the quality of the board 20. Buffer gates (not shown) may be located in the area 19 for signal connections to other circuits of the same logic deck. As shown in Figs. 2 and 3, a domain area 22 may include a predetermined number of I.C. packages 26 such as dual-in-line packages (DIP) or a Macrocell package 27 which is commercially available from Motorola Corp. of Phoenix, Arizona, U.S.A. Each lead element or pin 28 of the DIP packages 26 and the Macrocell package 27 is connected to a monitor point or hole 30 by a 2.5 millimeter copper bridge element 32. The monitor holes 30 may also be connected to circuit elements such as connecting pads or conductor elements located within the printed circuit board and are used for testing and repairing the circuit elements in a manner that will be explained more fully hereinafter.

Also mounted in the domain areas 22 are terminating resistors 36, tantalum capacitors 34 and ceramic capacitors 35. Both capacitors 34 and 35 function to smooth voltage fluctuations on the power conductors. In Figs. 2 and 3, the symbol $\triangle$ represents the location of a minus 5 VDC power source, the symbol X represents a minus 2 VDC power source, the symbol $\boxtimes$ represents the ground return for the power sources, the symbol $\square$ represents the location of IC package pins 28, the symbol O represent the location of a monitor hole 30, and the symbol + represents the possible location of connecting holes 31 which provide inter-layer connections. Each domain area 22 of the circuit board is constructed to have the same number of monitor and connecting holes. Also located on the circuit board within each domain area and adjacent each of the I.C. packages 26 (Fig. 2) and 27 (Fig. 3) is a row of holes 38 for mounting passive components associated with the circuit, such as resistors 36, etc.

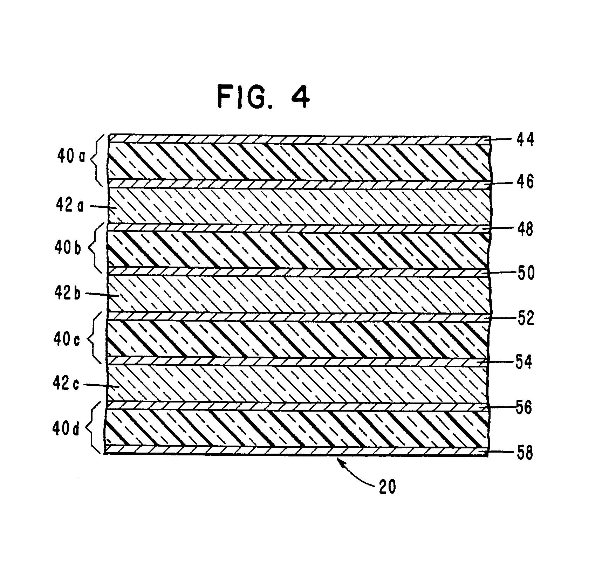

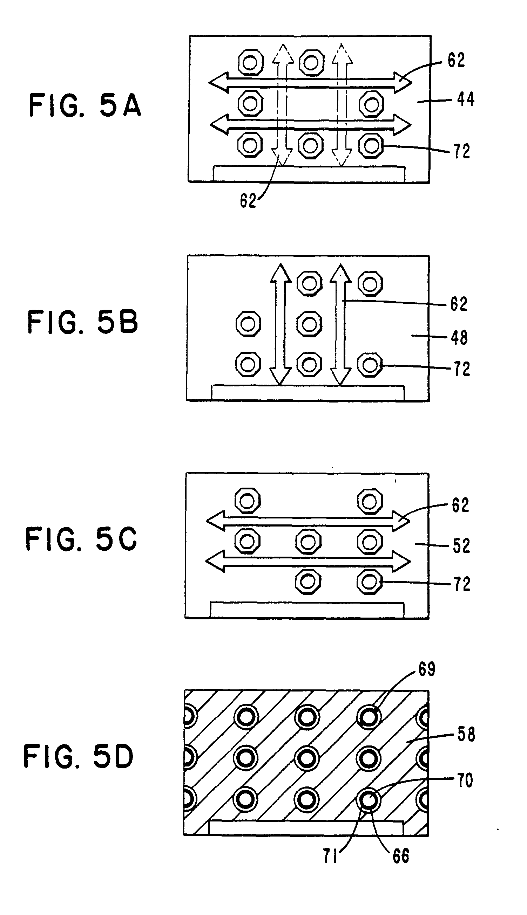

Referring now to Fig. 4, there is shown a cross-sectional view of a portion of the printed circuit board 20 of the present invention which is comprised of four double sided copper layer printed circuit cards 40a-40d, inclusive, bonded together in a stacked relationship by layers of dielectric material 42a-42c inclusive. The four circuit cards are constructed of an epoxy-glass material while the laminated layers 42a-42c inclusive are of a similar dielectric material. An etching process well known in the art provides a pattern of lines comprising conductor elements or foils 62 and connecting pads 72 (Fig. 5A-5C inclusive) in the upper copper layers 44, 48, 52, and 56 (Fig. 4) of cards 40a-40d inclusive. Layers 44, 48, 52 and 56 are designated signal layers over which signals associated with the operation of the circuit are transmitted. In operation, the copper layer 46 (Fig. 4) is connected to a minus 5.2 volts D.C. power supply while the layer 54 is connected to a minus 2 volts D.C. power supply. The copper layers 50 and 58 are connected to ground.

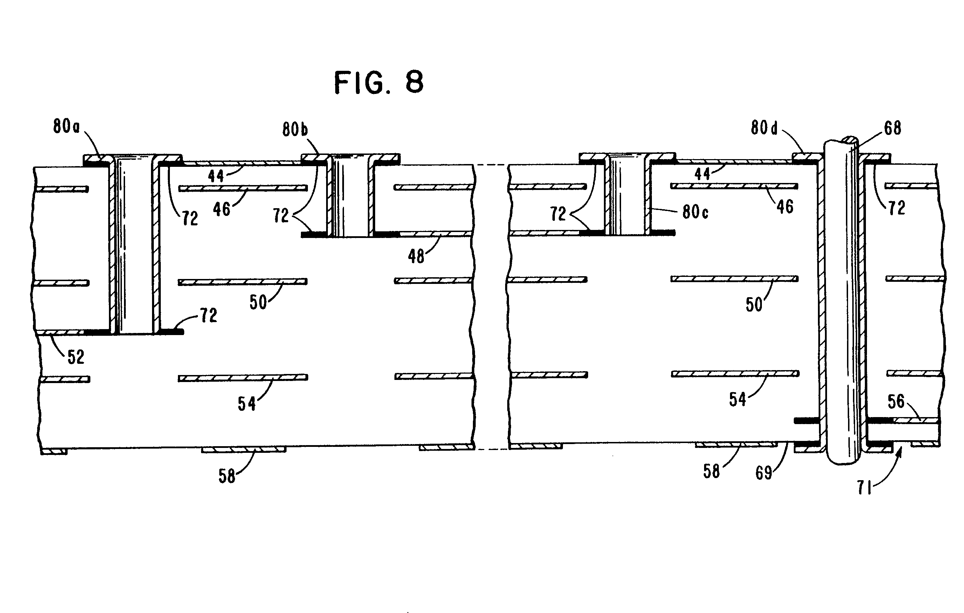

Referring now to Figs. 5A-5D inclusive, there are shown plan views of portions of the copper layers 44, 58, 52 and 56. The arrangement of the conductor elements 62, shown in Figs. 5A-5C inclusive, is intended to maximize the density of the circuit elements in a board using the circuit packages 26 (Fig. 2). The top or utility copper layer 44 (Fig. 5A) has lines of parallel conductor elements 62 extending in either the X or Y direction but, in any case the lines may never intersect each other. The, conductor elements 62 (Fig. 5B) located in the layers 48 and 56 are parallel and extend in the Y direction while the conductor elements 62 (Fig. 5C) located in the copper layer 52 and parallel and extend in the X direction. The conductor elements 62 are arranged so that the domain areas of the signal layers 44, 48, 52 and 56 each contain the same number of conductor elements 62. This uniform arrangement of the conductor elements 62 produces uniform stress and heat dissipation within the board, thus reducing the amount of warpage that may occur. The sandwiching of the power layers 46, 50 and 54 (Fig. 4) between the signal layers 44, 48, 52 and 56 further reduces the noise level. The lower ground layer 58 (Fig. 5D) includes soldering pads 66 which may be positioned to interconnect plated-through holes 70 with the ground layer 58 through a void or recessed portion 71 (Fig. 8) of the ground layer 58. These connections are made through the use of spoke elements 69 (Fig. 5D and 8) which bridge the recessed portion 71 to make connections between the pads 66 and the layer 58. Each hole 70 may comprise a monitor hole 30 (Fig. 2), a connecting hole 31, or the hole which receives a lead pin from an I.C. package.

Located in certain of the holes 70 are connecting pins 68 (Fig. 8) which are used to interconnect the layers of the printed circuit board by means of connecting pads 72 (Figs. 5A-5C inclusive) in a manner to be described more fully hereafter. The connecting pins 68 may comprise the pins of I.C. packages 26, 27 (Figs 2 and 3) or separate pins. The pads 72 interconnect pins 68 with other circuit elements and with the copper layers in which the pads are located. The inserted pins 68 are soldered to the board 20 through holes 70 and pads 72. Because the pads 72 and the conductor elements 62 have their designated locations in the layers, a pad will never block the way of a conductor element.

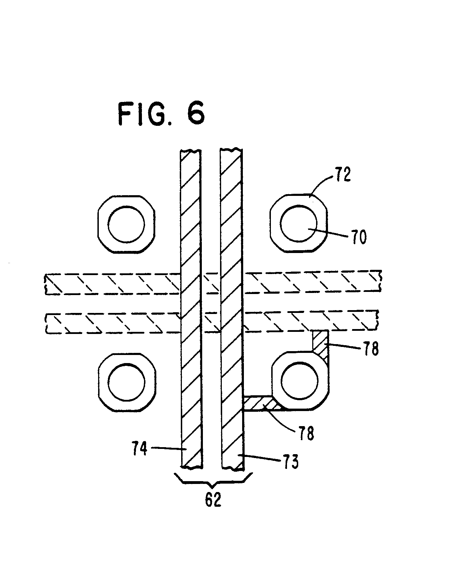

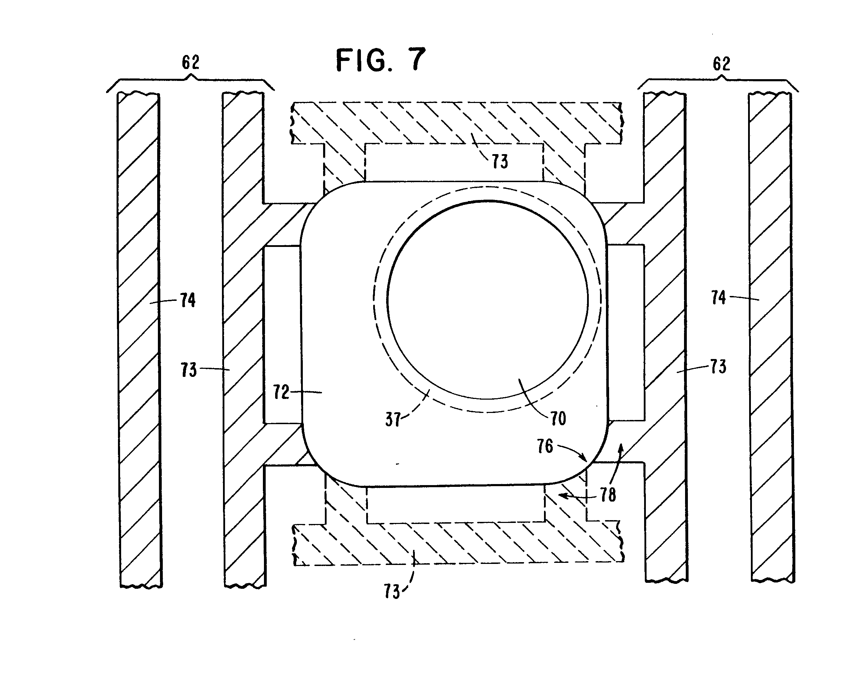

Referring now to Figs. 6 and 7, there is shown details of the connecting pads 72 and the conductor elements 62. As best shown in Fig. 6, each of the conductor elements 62 (Figs 5A-5C inclusive) consists of two parallel conductor segments 73, 74 through which electrical signals are transmitted. As shown more clearly in Fig. 7, each connecting pad 72 is formed of copper in a generally square configuration having curved corner portions 76. Each pad 72 is connected at one of its corner portions 76 to one of the conductor segments 73, or 74 by a connecting element 78 composed of the same material as the conductor elements 62, which in the present embodiment is copper. This arrangement allows the required electrical connection to be made between the pad 72 and the segments 73, 74. The splitting of the conductor element 62 into the segments 73 and 74 is made to maintain a constant density of conductor elements which produces less crosstalk between the conductor elements 62 and provides an easier access to any of the pads 72. The size of a pad 72 (Fig. 7) must be such that it is possible to make connections to the conductor elements 62 under the worst case conditions of artwork and manufacturing tolerances. It has been found that a square pad, being connected to a connecting element 78 at a curved corner portion, can tolerate a larger hole 70 than a round pad whose diameter is equal to a side of the square pad. Preferably, adjacent corners of a pad 72 are respectively connected to two connecting elements 78. With this arrangement, a conductor segment 73 or 74 will remain connected with an associated pad in the event that one of the corner portions 76 of the pad is broken off during the off center drilling of the respective hole 70. This double connection arrangement provides a way to select a smaller pad for an extremely dense packaging condition. Fig. 7 shows an off-center drilled hole 70 after it has been plated with a copper layer 37.

Referring now to Fig. 8, there is shown a simplified enlarged cross-sectional view of a portion of the printed circuit board 20 which illustrates the signal path extending between two of the copper layers of the circuit board using the connecting pads 72 and the mounting of a connecting pin 68 within a plated through hole 70. If a signal is to be transmitted from a particular conductor element of layer 52 to a particular conductor element of layer 56, the signal may be transmitted from layer 52 through the plated through hole 80a, the layer 44, the plated-through hole 80b, the layer 48, the plated-through hole 80c, layer 44 and the plated-through hole 80d to layer 56. Thus, a signal path is completed using the connecting pads 72 and the plated-through holes 80a-80d inclusive.

In fabricating the circuit board 20, each of the glass-epoxy cards 40a-40d inclusive (Fig. 4) is first prepared by laminating a copper layer to both sides of the card. The pattern of lines of conductor elements 62, 64 (Fig. 5A-5C) inclusive and the ' required connecting pads 72 on the cards 40a-40d inclusive are then made by the application of a mask and etching process to the copper layer in a manner that is well known in the art. After the cards 40a-40d inclusive have been prepared in this manner, they are assembled in the proper order by the sandwiching of the laminated glass-epoxy layers 42a-42c inclusive between the cards. Once the circuit board is formed, the required holes 70 (Fig. 7) are then drilled through the circuit board at a depth (Fig. 8) which intersects the selected connecting pads 72 to provide the required connections between the circuit elements and the conductor elements in the various layers. The holes 70 are then plated with a copper layer 37 (Fig. 7) in a manner that is well known in the art, after which the required connecting pins 68 (Fig. 8), which may be separate pins or the lead pins of the circuit elements 34, 26 etc., are then inserted in the appropriate holes 70 in the board. It will be seen that the fabrication of a circuit board having the construction as just described reduces the occurrence of mistakes since the method is always the same.

If, after the printed circuit board has been assembled, a circuit defect is found within the layers of the board, a repair can be made by cutting the appropriate bridge element 32 (Fig. 2) which extends between a lead pin 68 of a circuit element and a monitor hole 30 connected to the defective circuit element. This operation isolates the defective circuit element allowing tests to be made using the monitor hole 30 to determine the nature of the defect. It is obvious that the bridge element 32 can be repaired if the cause of the defect condition has been corrected.

Thus, the construction of the printed circuit board facilitates repair of the circuit elements without the need for expensive equipment to work into the inner layer of the board.

## Claims

1. A multilayer printed circuit board (20)' including a plurality of substrates (40a-40d) of electrically insulating material bonded together in a stacked relationship and each having a first surface on which is formed a pattern (44, 48, 52, 56) of electrically conductive material, a plurality of circuit elements (26) mounted on said first surface of an end one (40a) of said substrates, and a plurality of plated-through holes (70) extending transversely to the substrates, wherein said pattern of conductive material of each substrate includes a plurality of parallel conductors (73, 74), a plurality of connecting pads (72) each having a plated-through hole (70) passing therethrough and each having a generally square configuration with rounded corners, and a plurality of connecting elements (78) each connecting a corner of an associated connecting pad (72) to an adjacent one of said parallel conductors (73, 74).

2. A printed circuit board according to claim 1, wherein each of said connecting pads (72) is connected to an adjacent one of said parallel conductors (73, 74) by two connecting elements (78) respectively connected to adjacent corners of the pad (72).

3. A printed circuit board according to either claim 1 or claim 2, wherein said first surface of each of said substrates 40a-40d) comprises a plurality of equal surface areas 22) each containing the same number of parallel conductors (73, 74).

4. A printed circuit board according to claim 3, wherein said equal surface areas (22) of said end one (40a) of said substrates each contain the same number of integrated circuit packages (26).

5. A printed circuit board according to any one of the preceding claims, wherein a plurality of conductive layers (46, 50, 54, 58) are respectively provided on the surfaces of said substrates (40a-40d) opposite the said first surfaces, each of said conductive layers being adapted to be maintained in operation at a predetermined potential, and said conductive layers alternating with said patterns of conductive material.

6. A printed circuit board according to any one of the preceding claims, wherein said circuit elements (26) include a plurality of lead elements (28), each of said lead elements being mounted within a plated-through hole (70) and being located adjacent a respective monitor hole (30) to which the lead element is connected via a metallic bridge element extending along a surface of the printed circuit board, each said bridge element being severable.

**Patentansprüche**

1. Eine gedruckte Vielschichtschaltungsplatte (20) mit einer Vielzahl von Substraten (40a-40d) von elektrisch isolierendem Material, die in einer gestapelten Beziehung miteinander verbunden sind und die jeweils eine erste Fläche aufweisen, auf der ein Muster (44, 48, 52, 56) aus elektrisch leitendem Material ausgebildet ist, einer Vielzahl von Schaltungselementen (26), die auf der ersten Fläche eines endseitigen (40a) der Substrate angebracht sind, und einer Vielzahl von durchplattierten Öffnungen (70), die sich durch die Substrate hindurch erstrecken, wobei das Muster von leitendem Material jedes Substrats eine Vielzahl paralleler Leiter (73, 74), eine Vielzahl von Anschlußflecken (72), von denen jeder eine hindurchverlaufende hindurchplattierte Öffnung (70) aufweist und jeder eine im wesentlichen quadratische Ausbildung mit gerundeten Ecken hat, und eine Vielzahl von Verbindungselementen (78) aufweist, von denen jedes eine Ecke eines zugeordneten Verbindungsfleckens (72) mit einem benachbarten der parallelen Leiter (73, 74) verbindet.

2. Eine gedruckte Schaltungsplatte nach Anspruch 1, jeder verbindungsflecken (72) mit einem benachbarten der parallelen Leiter (73, 74) mittels zweier Verbindungselemente (78) entsprechend mit den benachbarten Ecken des Fleckens (72) verbunden ist.

3. Eine gedruckte Schaltungsplatte entweder nach Anspruch 1 oder Anspruch 2, wobei die erste Fläche jedes Substrats (40a-40d) eine Vielzahl gleicher Flächenbereiche (22) aufweist, von denen jeder die gleiche Anzahl paralleler Leiter (73, 74) enthält.

4. Eine gedruckte Schaltungsplatte nach Anspruch 3, wobei die gleichen Flächenbereiche (22) des endseitigen (40a) der Substrate jeweils die gleiche Anzahl von integrierten Schaltungspackungen (26) enthält.

5. Eine gedruckte Schaltungsplatte nach einem der vorhergehenden Ansprüche, wobei eine Vielzahl leitender Schichten (46, 50, 54, 58) entsprechend auf den Flächen der Substrate (40a-40d) entgegengesetzt zu den ersten Flächen vorgesehen ist, wobei jede der leitenden Schichten geeignet ist, im Betrieb auf einem vorbestimmten Potential gehalten zu werden, und die leitenden Schichten sich mit den Mustern von leitendem Material abwechseln.

6. Eine gedruckte Schaltungsplatte nach einem der vorhergehenden Ansprüche, wobei die Schaltungselemente (26) eine Vielzahl von Leiterelementen (28) aufweisen, wobei jedes der Leiterelemente innerhalb einer durchplattierten Öffnung (70) angebracht ist und benachbart zu einem entsprechenden Überwachungsloch (30) angeordnet ist, mit dem das Leiterelement mittels eines metallischen Brückenelementes verbunden ist, das sich längs einer Fläche der gedruckten Schaltungsplatte erstreckt, wobei jedes Brückenelement trennbar ist.n

**Revendications**

1. Plaquette à circuits imprimés multicouches (20) comprenant plusieurs substrats (40a-40d) en matière électriquement isolante, liés entre eux dans une disposition empilée et présentant chacun une première surface sur laquelle est formé un dessin (44, 48, 52, 56) en matière électriquement conductrice, plusieurs éléments de circuits (26) montés sur ladite première surface d'un premier, extrême (40a), desdits substrats, et plusieurs trous métallisés (70) s'ètendant transversalement aux substrats, ledit dessin de matière conductrice de chaque substrat comprenant plusieurs conducteurs parallèles (73, 74), plusieurs plots (72) de connexion traversés chacun d'un trou métallisé (70) et ayant chacun une configuration globalement carrée à angles arrondis, et plusieurs éléments (78) de connexion connectant chacun un angle d'un plot associé (72) de connexion à l'un, adjacent, desdits conducteurs parallèles (73, 74).

2. Plaquette à circuit imprimé selon la revendication 1, chacun desdits plots de connexion (72) étant connecté à l'un, adjacent, desdits conducteurs parallèles (73, 74) par deux éléments de connexion (78) connectés respectivement à des angles adjacents du plot (72).

3. Plaquette à circuits imprimés selon la revendication 1 ou la revendication 2, ladite première surface de chacun desdits substrats (40a-40d) comprenant plusieurs zones de surface égale (22) contenant chacune le même nombre de conducteurs parallèles (73, 74).

4. Plaquette à circuits imprimès selon la revendication 3, lesdites zones de surface égale (22) dudit premier, extrême (40a), desdits substrats contenant chacune le même nombre de boîtiers (26) de circuits intégrés.

5. Plaquette à circuits imprimés selon l'une quelconque des revendications précédentes, plusieurs couches conductrices (46, 50, 54, 58) étant prèvues respectivement sur les surfaces desdits substrats (40a-40d) opposées auxdites premières surfaces, chacune desdites couches conductrices étant conçue pour être maintenue en fonctionnement à un potentiel prédéterminé, et lesdites couches conductrices alternant avec lesdits dessins en matière conductrice.

6. Plaquette à circuits imprimés selon l'une quelconque des revendications précédentes, lesdits éléments de circuits (26) comprenant plusieurs éléments conducteurs (28), chacun desdits éléments conducteurs étant monté dans un trou métallisé (70) et étant placé à proximité immédiate d'un trou pilote correspondant (30) auquel l'élément conducteur est connecté par un élément de pontage métallique s'étendant le long d'une surface de la plaquette à circuits imprimés, chaque élément de pontage pouvant être sectionné.

# FIG. 1

24

19

25

23

22

20

21

# FIG. 2

# FIG. 3

35  34  38  36  36  31  30  32  22  28  26  32

# FIG. 4

FIG. 5A

FIG. 5B

FIG. 5C

FIG. 5D

# FIG. 6

FIG. 7

# FIG. 8

EP 0 253 833 B1